# EUROPÄISCHE PATENTANMELDUNG

(11) **EP 1 848 254 A2**
(43) Veröffentlichungstag der Anmeldung: **24.10.2007**
(21) Anmeldenummer: 07006010.8
(22) Anmeldetag: 23.03.2007
(51) Int. Cl.: H05K 1/14, H05K 1/11, H05K 1/02

(54) **Leiterplattenmodul**

(30) Priorität: 24.03.2006 DE 202006005045 U
(71) Anmelder: Würth Elektronik Rot am See GmbH & Co. KG, 74585 Rot am See (DE)
(72) Erfinder: Benjo, Andreas, 74572 Blaufelden (DE); Park, Heyje, 74572 Blaufelden (DE); Kostelnik, Jan, 74592 Kirchberg (DE)
(74) Vertreter: Patentanwälte Ruff, Wilhelm, Beier, Dauster & Partner

(57) **Zusammenfassung**

Die Erfindung schlägt ein Leiterplattenmodul vor, das eine Leiterplatte mit in der Leiterplatte angeordneten Leiterbahnen aufweist. An der Leiterplatte ist mindestens eine Verbindungseinrichtung ausgebildet, mit deren Hilfe diese Leiterplatte mit einer ähnlichen Leiterplatte direkt mechanisch und elektrisch verbunden werden kann, die eine gleiche oder ähnliche Verbindungseinrichtung aufweist. Das Leiterplattenmodul kann beispielsweise an einer Flachseite oder an einer Kante eine Leuchtdiode aufweisen, die durch in der Leiterplatte vorhandene Leiterbahnen mit Strom versorgt wird.

## Beschreibung

Die Erfindung betrifft ein Leiterplattenmodul.

Es sind Leiterplattenmodule bekannt, die nicht in Geräte eingebaut werden, sondern die bestimmte Funktionen auch außerhalb von Geräten übernehmen sollen. Beispielsweise kann es sich um Leiterplatten mit Beleuchtungen handeln, deren einziger Zweck darin besteht, an bestimmten Stellen Anzeigen erscheinen zu lassen.

So ist es bereits bekannt, derartige LEDs enthaltende Module mit Kabeln zur Bildung von Ketten von Modulen zu verbinden (US 2005/0122293).

Weiterhin ist es bekannt, derartige Module mit Kontaktierungsverbindungen zu versehen (DE 10121136).

Der Erfindung liegt die Aufgabe zu Grunde, eine Möglichkeit zu schaffen, Leiterplattenmodule mit geringem Aufwand universell miteinander verbinden zu können, ohne zusätzliche oder spezielle angefertigte Verbindungseinrichtungen zu benötigen.

Zur Lösung dieser Aufgabe schlägt die Erfindung ein Leiterplattenmodul mit den im Anspruch 1 genannten Merkmalen vor. Weiterbildungen der Erfindung sind Gegenstand von Unteransprüchen.

Bei dem von der Erfindung vorgeschlagenen Leiterplattenmodul ist an dem Leiterplattenmodul selbst eine Verbindungseinrichtung ausgebildet, die zur direkten unmittelbaren Verbindung mit einem anderen Leiterplattenmodul ausgebildet und geeignet ist, das die gleiche oder gleichartige Verbindungseinrichtung aufweist. Dadurch wird es möglich, ohne Zwischenelemente zwischen zwei Leiterplattenmodulen auszukommen, und es wird auch möglich, größere Ketten von Leiterplattenmodulen aus identischen Leiterplattenmodulen aufzubauen.

Um bei einer solchen Kette von Leiterplattenmodulen die Leiterbahnen mit Strom und/oder mit Signalen zu versorgen, kann erfindungsgemäß ein Leiterplattenmodul eine Ankopplungseinrichtung aufweisen, die beispielsweise mit einem Stecker oder mit Steckerstiften verbindbar ist. Ein solches Modul, bei dem die Einkopplung der Stromversorgung erfolgt, kann man auch als Endmodul bezeichnen, da es am Ende oder am Anfang einer solchen Kette von Leiterplattenmodulen angeordnet wird. Es ist dann beispielsweise nur mit einer einzigen weiteren Leiterplatte zu verbinden.

In Weiterbildung der Erfindung können Mittelmodule gebildet sein, die sich dadurch auszeichnen, dass sie zwei Verbindungseinrichtungen zur Verbindung mit zwei anderen Modulen aufweisen. Auch hier sind die Verbindungseinrichtungen wieder direkt an dem Modul ausgebildet.

Die Module sollen natürlich bestimmte Aufgaben übernehmen. Im einfachsten Fall kann, gerade bei einer größeren Kette von Modulen, ein Modul vorhanden sein, das keine andere Aufgabe hat, als zwei andere Module mechanisch und elektrisch zu verbinden. Es hat also nur durchgehende Leiterbahnen, die innerhalb dieses Moduls nicht mit anderen Dingen verbunden sind.

Das die Aufgabe der Ankopplung übernehmenden Modul wurde bereits als Sondermodul erwähnt.

In Weiterbildung der Erfindung kann vorgesehen sein, dass ein Modul mindestens eine LED aufweist, die mit den Leiterbahnen verbunden ist, die durch das Modul hindurch führen.

Ebenfalls möglich ist es, dass ein Modul ein mithilfe der Leiterbahnen mit Strom versorgtes elektronisches Bauteil aufweist, zur Bildung eines Funktionsmoduls.

In nochmaliger Weiterbildung der Erfindung kann vorgesehen sein, dass ein Modul ein Logikbauteil aufweist, zur Bildung eines Logikmoduls.

In Weiterbildung der Erfindung sieht diese vor, dass das Leiterplattenmodul leistenförmig ausgebildet ist, wobei hier insbesondere die Form einer flachen Leiste bevorzugt ist, bei der eine Breitseite die Vorderseite und eine Breitseite die Rückseite des Leiterplattenmoduls bildet. Es ist jedoch auch möglich, dass die Leiste einen quadratischen oder angenähert quadratischen Querschnitt aufweist, zur Bildung eines Stabes.

Die Leiste kann eine abgewinkelte Leiste sein, sie kann auch eine Abzweigung aufweisen, so dass das Leiterplattenmodul drei bzw. auch mehr als drei Verbindungsstellen aufweist, von denen gegebenenfalls jede Verbindungsstelle mit einer Verbindungseinrichtung zur Kopplung mit einem gleichartigen Modul versehen ist.

Das Modul kann insbesondere als geradlinig verlaufende Leiste ausgebildet sein. Hier liegen also nicht nur die Vorderseite und die Rückseite in jeweils einer Ebene, sondern auch die Oberseite und Unterseite, die man auch als Kanten bezeichnen kann.

Erfindungsgemäß kann in Weiterbildung auch vorgesehen sein, dass es sich bei der Leiste um eine gebogene Leiste handelt, wobei die Krümmung in einer Dimension vorliegt. Beispielsweise liegen bei einer flachen Leiste die Vorderseite und die Rückseite weiterhin in einer Ebene, während die Oberkante und die Unterkante gekrümmt verlaufen.

Erfindungsgemäß kann es sich bei dem Leiterplattenmodul sowohl um eine starre Leiterplatte als auch um eine starr-flexible Leiterplatte handeln.

In Weiterbildung der Erfindung kann vorgesehen sein, dass die Verbindungseinrichtung derart ausgebildet ist, dass zwei benachbarte Module in unterschiedlichen Positionen miteinander verbindbar sind, wobei die unterschiedlichen Positionen sich in unterschiedlichen Winkelstellungen um eine Achse unterscheiden, die senkrecht zu der Vorderseite beziehungsweise Rückseite des Leiterplattenmoduls im Bereich der Verbindung verläuft.

Die Verbindungseinrichtung kann beispielsweise so sein, dass die einzelnen Module in diesen verschiedenen Positionen steckbar miteinander verbunden werden.

Die Verbindungseinrichtung kann in Weiterbildung so ausgebildet sein, dass bei hergestellter Verbindung die Vorderseiten und Rückseiten der beiden benachbarten Module auch im Bereich der Verbindung in der gleichen Ebene liegen.

Insbesondere hat es sich als sinnvoll herausgestellt, die Verbindungseinrichtung scharnierartig auszubilden, das heißt mit einem eine Achse bildenden Verbindungselement, um das dann die beiden Module verschwenkbar sind.

Zur Herstellung der elektrischen Verbindungen kann die Verbindungseinrichtung Kontaktelemente aufweisen, die so ausgebildet sind, dass die Kontaktelemente der Verbindungseinrichtung der einen Leiterplatte flächig an den Kontaktelementen der Verbindungseinrichtung des anderen Leiterplattenmoduls anliegen. Dabei kann das mechanische Verbindungselement, beispielsweise eine Schraube, dazu dienen, eine ausreichende Flächenpressung herzustellen.

Insbesondere können die Kontaktelement als Schleifringe ausgebildet sein, die in beliebigen Winkelpositionen eine elektrische Verbindung gewährleisten.

Erfindungsgemäß kann vorgesehen sein, das ein mechanisches Verbindungselement, beispielsweise ein die Scharnierachse bildendes Verbindungselement, als Leiter wirkt.

Als mechanisches Verbindungselement können mit Muttern versehene Schrauben, sich ihr Gewinde selbst schneidende Schrauben, Niete, Blindniete oder dergleichen dienen.

Es kann erfindungsgemäß vorgesehen sein, dass die Verbindungseinrichtungen mehr als zwei Leiterbahnen miteinander verbinden, so dass in den Leiterplattenmodulen auch mehrere Stromkreise angeordnet sein können. Dies kann beispielsweise so geschehen, das Schleifringe als konzentrische Kreise ausgebildet werden.

Die Verbindungseinrichtung kann mechanisch beispielsweise so ausgebildet sein, dass von der Vorderseite des Leiterplattenmoduls ausgehend eine Stufe gebildet ist, auf deren Oberfläche die Schleiferinge angeordnet sind. Dann wird das benachbarte Leiterplattenmodul in umgekehrter Anordnung verbunden, so dass die Vorderseiten und Rückseiten der beiden benachbarten Module tatsächlich in der gleichen Ebene liegen.

Es ist auch möglich und wird von der Erfindung vorgeschlagen, als Verbindungseinrichtung zwischen zwei benachbarten Leiterplattenmodulen eine Schubgelenkverbindung vorzusehen. Diese Schubgelenkverbindung kann insbesondere einen Längenausgleich aufweisen, um Toleranzen bei der Anbringung ausgleichen zu können.

Das Leiterplattenmodul kann in Weiterbildung der Erfindung einen mehrlagigen Aufbau aufweisen.

Erfindungsgemäß kann das Leiterplattenmodul eine Buchse aufweisen, beispielsweise eine Steckbuchse. Diese kann dazu dienen, elektrische und/oder Steuerverbindungen herzustellen oder durchzuführen. Insbesondere kann es sich dabei um eine Klinkensteckerbuchse oder aber auch um eine USB-Schnittstelle handeln, bei der nicht nur die mechanische Form normiert ist, sondern auch die elektrischen Eigenschaften.

Eine solche Steckbuchse, beispielsweise auch eine USB Steckbuchse, kann dazu dienen, eine Energieversorgungseinheit anzustecken.

Weitere Merkmale, Einzelheiten und Vorzüge der Erfindung ergeben sich aus den Ansprüchen, deren Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Figur 1: eine Stirnansicht eines Leiterplattenmoduls;
- Figur 2: die Draufsicht auf die Anordnung der Figur 1;
- Figur 3: die Ansicht der Leiterplatte von links in Figur 1;
- Figur 4: die Stirnansicht eines weiteren Leiterplattenmoduls;
- Figur 5: die Draufsicht auf das Leiterplattenmodul der Figur 4;
- Figur 6: die Draufsicht auf eine weitere Ausführungsform eines Leiterplattenmoduls;
- Figur 7: die Stirnansicht eines starr-flexiblen Leiterplattenmoduls;
- Figur 8: die Draufsicht auf die Anordnung der Figur 7;
- Figur 9: die Stirnansicht zweier miteinander verbundener Leiterplattenmodule;
- Figur 10: die Draufsicht auf mehrere miteinander verbundene Leiterplattenmodule;
- Figur 11: die perspektivische Ansicht eines eine Abzweigung aufweisenden Leiterplattenmoduls;
- Figur 12: ein abgewinkeltes Leiterplattenmodul;
- Figur 13: einen Schnitt durch ein Ende eines Leiterplattenmoduls;
- Figur 14: einen der Figur 13 entsprechenden Schnitt bei einer geänderten Ausführungsform;
- Figur 15: einen Schnitt durch den Endbereich bei einer nochmals weiteren Ausführungsform;
- Figur 16: schematisch eine Verbindungsstelle zur sternförmigen Verbindung dreier Leiterplattenmodule an einer Stelle;
- Figur 17: vereinfacht ein Leiterplattenmodul mit scharnierartigen Anordnungen an beiden Enden.
- Figur 18: eine schematische Darstellung der Verbindungsstelle zwischen zwei Leiterplattenmodulen;
- Figur 19: eine Draufsicht auf die Verbindungsstelle zweier Leiterplattenmodule;
- Figur 20: eine der Figur 19 entsprechende Darstellung einer weiteren Ausführungsform;
- Figur 21: die Stirnansicht eines Leiterplattenmoduls;
- Figur 22: einen Querschnitt durch ein Leiterplattenmodul;
- Figur 23: die Stirnansicht eines mit dem Leiterplattenmodul der Figur 22 zusammenwirkenden Leiterplattenmoduls;
- Figur 24: die Seitenansicht der Ausführungsform der Figur 23;
- Figur 25: die Draufsicht auf eine Verbindungsstelle zwischen zwei Leiterplattenmodulen;
- Figur 26: die Ansicht der Anordnung von unten in Figur 25;
- Figur 27: schematisch die Verbindung zweier Module mit einem Hohlniet.

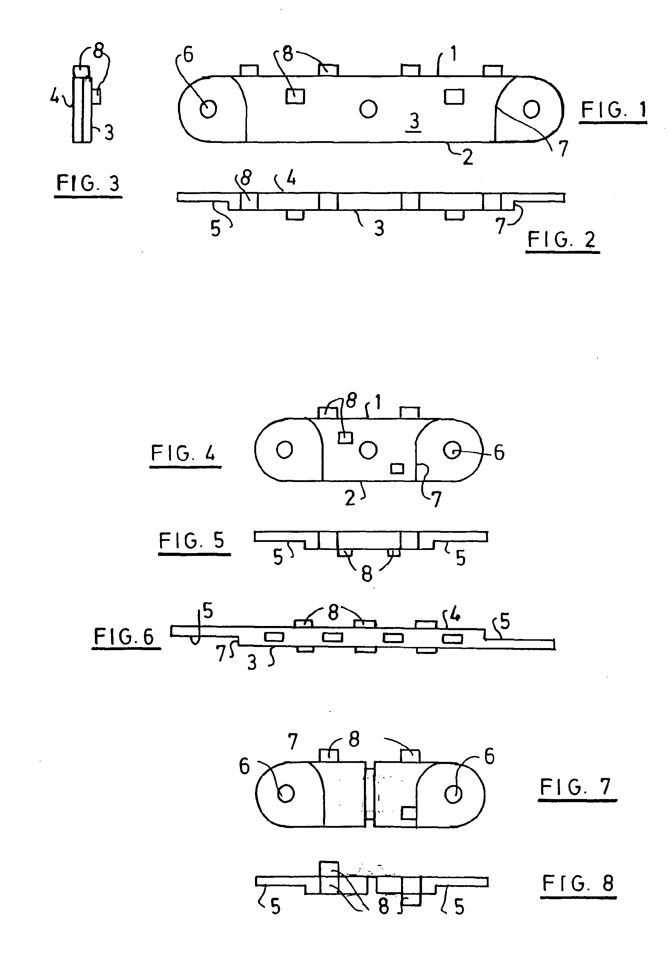

Die Figuren 1 bis 3 zeigen in drei verschiedenen Ansichten ein Leiterplattenmodul nach einer ersten Ausführungsform der Erfindung. Das Leiterplattenmodul ist als flache lang gestreckte Leiste ausgebildet, mit einer geradlinig verlaufenden Oberkante 1, einer hierzu parallel verlaufenden Unterkante 2, einer ebenen Vorderseite 3 und einer ebenen Rückseite 4. Im Bereich beider Enden ist die Leiste abgerundet. In diesem abgerundeten Endbereich verläuft die Vorderseite 3 abgestuft, so dass eine Stufe 5 gebildet ist, die etwa um die halbe Dicke des Leiterplattenmoduls nach hinten versetzt ist. In der Mitte des halbkreisförmig abgerundeten Endbereichs ist jeweils ein Loch 6 vorhanden. Die Begrenzungslinie 7 der Stufe 5 verläuft oberhalb einer Längsmittellinie längs des gleichen Kreisbogens wie der Endbereich selbst.

Etwa in der Mitte des Leiterplattenmoduls ist ein Loch ausgebildet, das eine reine Befestigungsfunktion hat.

An der Oberkante 1 des Leiterplattenmoduls sind im dargestellten Beispiel vier LEDs 8 angeordnet, die mit in dem Leiterplattenmodul vorhandenen Leiterbahnen in Verbindung stehen. Da die Kante 1 des Leiterplattenmoduls schmal ist, sind die LEDs 8 längs einer Linie angeordnet. Die Vorderseite 3 des Leiterplattenmoduls ist ebenfalls mit LEDs 8 versehen. Diese könnten auch auf unterschiedlicher Höhe angeordnet sein, wie dies die Frontseite 3 der Leiterplatte der Figur 4 zeigt

Die Figuren 4 und 5 zeigen ein ähnliches Leiterplattenmodul, das die gleiche Höhe, die gleiche Dicke und die gleiche Umfangsform im Endbereich aufweist wie das Leiterplattenmodul der Figuren 1 bis 3. Aus dem Vergleich der beiden Ausführungsformen ergibt sich, dass das Leiterplattenmodul der vorliegenden Erfindung sich in beliebigen Längen herstellen lässt.

Figur 6 zeigt ähnlich wie Figur 2 eine Kantenansicht eines weiteren Moduls. Bei diesem Leiterplattenmodul ist im Bereich des einen Endes die Stufe 5 auf der Rückseite 4 ausgebildet, während an dem anderen Ende die Stufe 5 auf der Vorderseite 3 des Leiterplattenmoduls ausgebildet ist. Dadurch lassen sich die einzelnen Module aneinander reihen, ohne sie umdrehen zu müssten. Bei dieser Ausführungsform sind LEDs 8 auf allen Seiten des Leiterplattenmoduls angeordnet.

Bei der Anordnung der Figur 7 ist ein Leiterplattenmodul starr-flexibel ausgebildet, was bedeutet, dass es in seinem mittleren Bereich einen flexiblen Abschnitt 10 aufweist, der es ermöglicht, die beiden jenseits des flexiblen Abschnitts angeordneten Teile in unterschiedlichen Ebenen anzuordnen. Der flexible Abschnitt 10, der die beiden Teile des Leiterplattenmoduls miteinander verbindet, ist beispielsweise im Bereich der Rückseite 4 des Leiterplattenmoduls ausgebildet. Dadurch lassen sich die beiden Teile beidseits des flexiblen Abschnitts 10 nach hinten zur Bildung einer Außenecke biegen. Aufgrund der Elastizität des Bereichs 10 ist daher auch eine Anordnung möglich, bei der beiden Teile des Leiterplattenmoduls nicht in einer Ebene liegen.

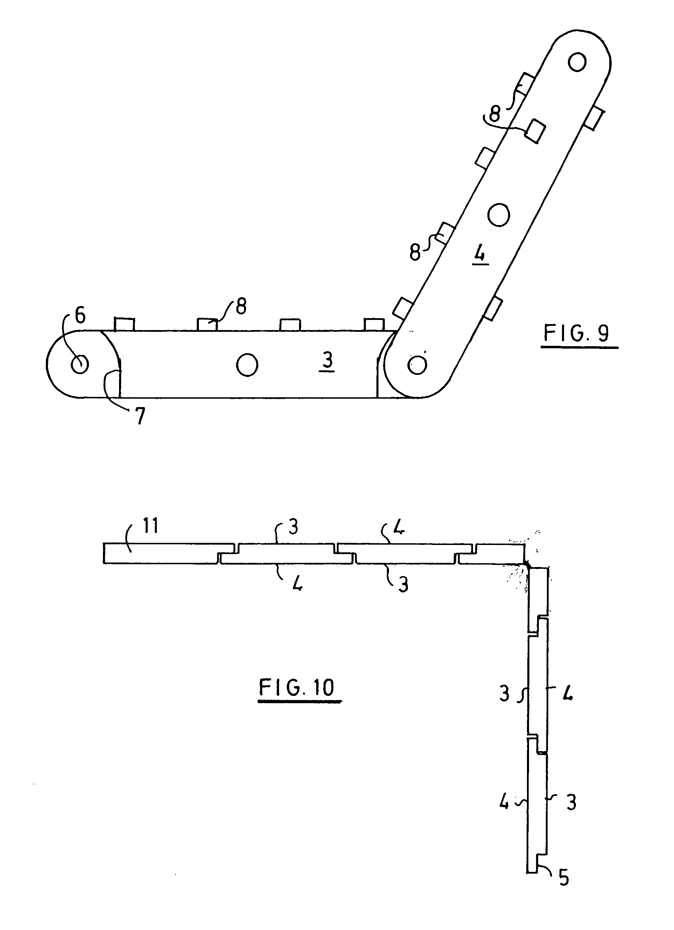

Die Figur 9 soll andeuten, wie zwei Module miteinander verbunden werden, und welche Anordnungen möglich sind. Mit dem rechten Ende eines Leiterplattenmoduls, wie es in Figur 1 dargestellt ist, ist das linke Ende eines weiteren Leiterplattenmoduls zur Verbindung fertig angeordnet. Da bei dem linken Leiterplattenmodul die Stufe 5 auf der Vorderseite ist, und die beiden Leiterplattenmodule in einer Ebene angeordnet sein sollen, ist das rechte Leiterplattenmodule umgedreht, so dass jetzt die Rückseite 4 zu sehen ist und die Stufe 5 auf der hier nicht zu sehenden anderen Seite. Aufgrund des Verlaufs der Begrenzungswand 7 der Stufe 5 lässt sich das rechte Modul nach oben bis zu der dargestellten Position verschwenken, bei einer Verschwenkung im Uhrzeigersinn ist auch eine Verschwenkung bis zu einem rechten Winkel möglich. Es lassen sich nach Wunsch auch größere Winkel nach oben herstellen, indem man die Begrenzungswand 7 anders gestaltet.

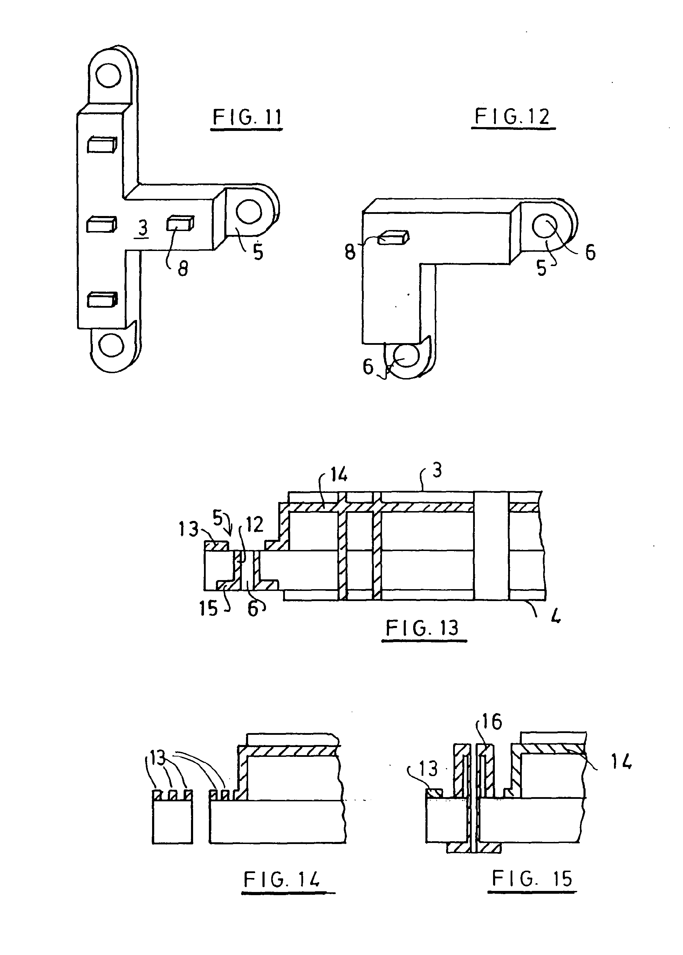

Die nächste Figur 10 soll nun ein Beispiel dafür zeigen, dass man mehrere Module in der unterschiedlichsten Weise miteinander kombinieren kann. Während die Figur 9 die Stirnansicht zeigt, zeigt die Figur 10 eine Ansicht von oben. Links beginnend ist ein Endmodul 11 vorhanden, bei dem das linke Ende dazu dienen kann, Strom einzukoppeln. Dies kann beispielsweise mithilfe von angelöteten Kabeln oder auch mithilfe einer Steckverbindung geschehen. Das rechte Ende dieses Endmoduls ist so ausgebildet, wie dies rechts in Figur 1 auch dargestellt ist. An das Endmodul schließt sich ein Modul an, bei dem die Rückseite 4 nach vorne gerichtet ist, anschließend wieder ein umgekehrt orientiertes Modul. Dann kommt ein Modul, wie es in Figur 7 dargestellt ist, dessen beide Teile über Eck angeordnet sind. An dieses schließen sich wiederum zwei jeweils abwechselnd unterschiedlich orientierte Module an. Durch die mittige Anordnung der Stufe 5 verlaufen die Vorderseiten und Rückseiten der gesamten Anordnung immer jeweils in einer Ebene.

Die Figur 11 zeigt, dass ein Modul auch die Form einer eine Abzweigung aufweisenden Leiste aufweisen kann, so dass drei Zweige mit jeweils einer Stufe 5 am Ende jeden Zweigs gebildet sind.

Figur 12 zeigt ein Modul, das ebenfalls als Leiste, aber diesmal als abgewinkelte Leiste ausgebildet ist. Im dargestellten Beispiel handelt es sich um eine rechtwinklige Abwinklung, was aber ebenfalls nicht erforderlich ist.

Während bei den Ausführungsformen nach Figur 1 bis Figur 10 die LEDs 8 auch auf der Oberkante 1 des jeweiligen Moduls angeordnet sind, zeigen die Figuren 11 und 12, dass es möglich ist, die LEDs auch nur auf der Vorderseite oder anders ausgedrückt der Frontseite 3 anzuordnen.

Zur mechanischen Verbindung der Module können Schrauben dienen, die durch die Löcher 6 der Enden der Module hindurch gesteckt und dann beispielsweise mit Muttern gesichert werden können. Die in ihrer Mitte mit dem Loch 6 versehene Stufe 5 bildet also, zusammen mit einem Verbindungselement in Form beispielsweise einer Schraube, eine Verbindungseinrichtung, um zwei Module miteinander mechanisch zu verbinden. Diese Verbindungseinrichtung ist, mit Ausnahme der Schraube als Verbindungselement, an dem Leiterplattenmodul selbst direkt ausgebildet.

In den folgenden Figuren 13 bis 15 wird gezeigt, dass diese mechanische Verbindungseinrichtung gleichzeitig eine elektrische Verbindung mit dem in den Leiterplattenmodulen -geführten Leiterbahnen herstellt. Figur 13 zeigt einen Längsschnitt durch den Endbereich eines Leiterplattenmoduls. Die mittig zu der Stufe 5 angeordnete Bohrung 6 ist als durchkontaktierte Bohrung ausgebildet, was bedeutet, dass ihre Wand mit einer metallischen Hülse 12 versehen ist. Auf der Rückseite 4 des Moduls, in Figur 12 unten, verbreitert sich diese Hülse 12 und bildet eine flache Scheibe, deren freie Oberfläche in einer Ebene liegt.

Auf der gegenüberliegenden, das heißt zur Vorderseite 3 des Leiterplattenmoduls gerichteten Seite der Stufe 5 ist die Durchkontaktierung in Form der Hülse 12 zunächst von einem konzentrischen Ring umgeben, in dem das Material der Leiterplatte nicht mit einem leitenden Belag versehen ist. Außerhalb dieses also isolierendem Ringbereichs ist eine Kontaktierung 13 vorhanden, die direkt in die Leiterbahnen 14 übergeht. Diese Kontaktierung 13 bildet einen Schleifring.

Legt man ein Leiterplattenmodul in umgekehrter Orientierung, das heißt mit der Rückseite 4 nach oben, mit seiner Stufe 5 auf die Stufe 5 des in Figur 13 dargestellten Leiterplattenmoduls in der Weise, dass die Bohrungen 6 der beiden Verbindungseinrichtungen miteinander fluchten, und führt man eine Schraube durch die Bohrungen 6 hindurch, so sind die beiden Leiterplattenmodule nach Art eines Scharniers miteinander verbunden, wobei dann, wenn man die Schraube fest zieht, die Schleifringe 13 aufeinander gepresst werden und dadurch eine leitende Verbindung herstellen. Auch die Schraube selbst, die mit der Unterseite ihres Schraubenkopfs auf der Scheibe 15 der Hülse 12 und mit der Mutter auf der gegenüberliegenden Scheibe 15 aufliegt, verbindet auf diese Weise die beiden durchkontaktierten Bohrungen 6.

Bei der Ausführungsform nach Figur 13 werden zwei getrennte Leiterstränge miteinander verbunden, nämlich zum einen durch die Verbindung der durchkontaktierten Bohrungen, und zum anderen durch den Kontakt zwischen den Schleifringen 13.

Es ist nun auch möglich, mehrere konzentrische Schleifringe anzuordnen, wie dies vereinfacht die Figur 14 darstellt. Hier hat man also drei Schleifringe, so dass man damit drei verschiedene und getrennte Leiterbahnen beidseits der Verbindungseinrichtung miteinander verbinden kann.

Die mechanische Verbindung zweier oder mehrerer Leiterplattenmodule 1 kann durch Hohlniete, Blindniete, Schrauben oder dergleichen erfolgen. Schrauben können zusätzlich dazu dienen, die Verbindungsstelle an einer Unterlage anzuschrauben. Durch die Verwendung elektrisch leitfähiger Materialien, beispielsweise Niete aus Metall und Schrauben aus Metall, kann gleichzeitig eine elektrische Verbindung hergestellt werden.

Soll im Einzelfall nur eine rein mechanische Verbindung hergestellt werden, oder soll die Verbindung nur durch das Aufeinanderliegen von Schleifringen oder Kontaktflächen erfolgen, können auch nicht leitende Materialien verwendet werden, beispielsweise Kunststoff-Blindniete.

Bei der Ausführungsform in Figur 15 ist in die Bohrung 6 eine Hülse 16 eingesetzt, die auf der gegenüberliegenden Seite, also der Stufe 5, bis zur Oberseite der Leiterbahnen 14 vorspringt. Er ist mit Abstand von einem Schleifring 13 umgeben. Mit dieser Art der Verbindungseinrichtung kann eine weitere Verbindungseinrichtung zusammenwirken, die eine im Durchmesser größere Bohrung 6 aufweist, die dem Außendurchmesser der Hülse 16 entspricht.

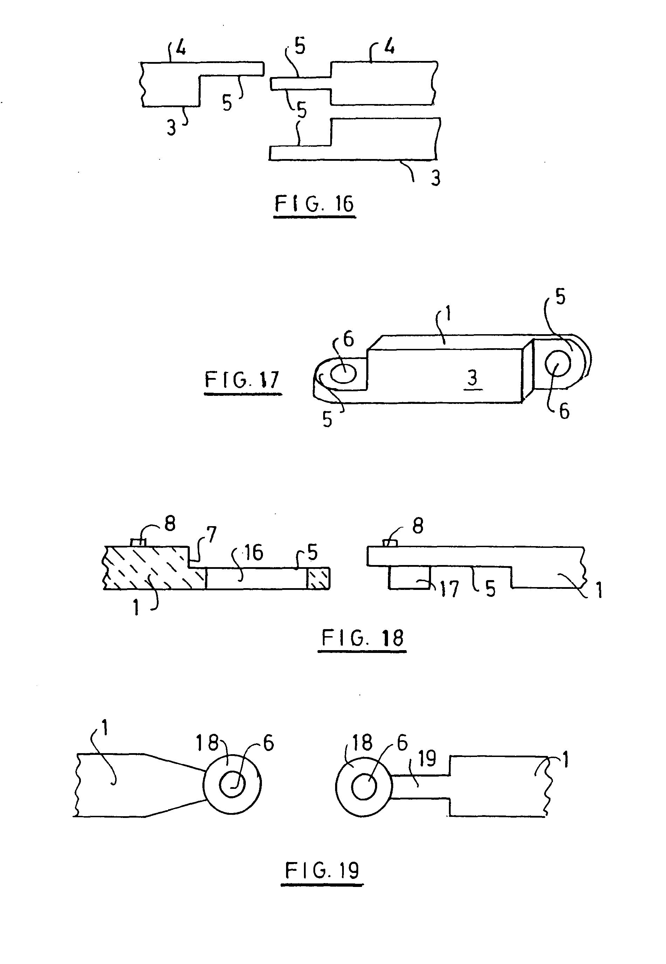

Figur 16 zeigt in abgebrochene Darstellung die Enden dreier Leiterplattenmodule, wobei die Stufe 5 bei dem linken Leiterplattenmodul von der Vorderseite 3 ausgeht und etwa zwei Drittel der Dicke der Leiterplatte entspricht, während dies bei dem rechten unteren Leiterplattenmodul gerade umgekehrt ist. Das rechte obere Leiterplattenmodul hat dem gegenüber zwei Stufen 5, von denen die eine von der Rückseite 4 und die andere von der Vorderseite 3 ausgeht. Klappt man das rechte untere Leiterplattenmodul um 90° gegenüber der Zeichnungsebene nach nach oben oder unten, so können an dieser Stelle drei Leiterplattenmodule sternförmig miteinander verbunden werden, bei denen weiterhin die Vorderseiten 3 und die Rückseiten 4 bündig in jeweils einer Ebene angeordnet sind.

Figur 17 zeigt ebenfalls stark vereinfacht ein Leiterplattenmodul, das einen etwa quadratischen Querschnitt aufweist. An dem einen Ende geht die Stufe 5 von der Oberseite 1 aus, und an dem anderen Ende von der Vorderseite 3. Dadurch können Verbindungen mit Scharnierachsen gebildet werden, die senkrecht aufeinander stehen und nicht parallel, wie bei den vorhergehenden Ausführungsformen. Es sind natürlich auch andere Winkel denkbar als der rechte Winkel zwischen den beiden Scharnierachsen bei der Ausführungsform nach Figur 17. Dadurch lassen sich Ketten von den Leiterplattenmodulen bilden, die eine Ebene verlassen.

Zur mechanischen und elektrischen Verbindungen dient in der Regel also ein mechanisches Verbindungselement, beispielsweise eine Schraube oder ein Niet, der durch die miteinander fluchtenden Bohrungen 6 der beiden Verbindungseinrichtungen hindurch gesteckt wird und dort eine Achse für das Scharnier bildet.

Während bei den bisherigen Ausführungsformen zur direkten mechanischen Verbindung beide Leiterplatten jeweils ein kreisrundes Loch aufweisen, durch das eine Schraube hindurch gesteckt werden kann, zeigt Figur 18 die Möglichkeit, wie zwei Leiterplattenmodule derart miteinander verbunden werden können, dass sie nur in gegenseitiger Verlängerung angeordnet werden können, aber einen gewissen Längenausgleich ermöglichen. Zu diesem Zweck hat das in Figur 18 links dargestellte Leiterplattenmodul 1 in dem die Stufe 5 aufweisenden Bereich ein Langloch 16. Das entsprechende Ende des rechts in Figur 18 dargestellten Leiterplattenmoduls hat auf seiner nach unten gerichteten Stufe 5 einen Ansatz 17, dessen Breite der Breite des Langlochs 16 entspricht, dessen Länge aber kürzer ist als die Länge des Langlochs 16. Dadurch kann, wenn der Ansatz 17 in dem Langloch 16 angeordnet ist, eine Verschiebung um die Differenz der beiden Längen erfolgen. Wenn es sich bei dem Ansatz 17 um einen hohlen Ansatz handelt, kann durch ihn eine Schraube hindurch gesteckt werden, die beispielsweise mit einer Unterlegscheibe auf der Unterseite eine Verspannung der beiden Leiterplattenmodule 1 bewirkt. Es ist natürlich auch möglich, die jeweils äußeren Enden der beiden Leiterplattenmodule 1 in der Weise zu befestigen, wie dies bei den Ausführungsformen nach den vorherigen Figuren möglich war.

Figur 19 zeigt zwei Möglichkeiten, wie die Endbereiche der Leiterplattenmodule, die die Löcher 6 aufweisen, anders gestaltet werden können. Bei der Ausführungsform links in Figur 19 verlaufen die Seitenkanten des Leiterplattenmoduls in Richtung auf eine Öse 18 konvergierend, während bei dem Leiterplattenmodul rechts in Figur 19 ein Verbindungssteg 19 zu der Öse 18 führt. Dieser Verbindungssteg ist mit parallelen Seitenkanten ausgebildet. Bei der Ausführungsform nach Figur 19 braucht die Stufe 5 nur im Bereich der Öse 18 selbst vorhanden zu sein.

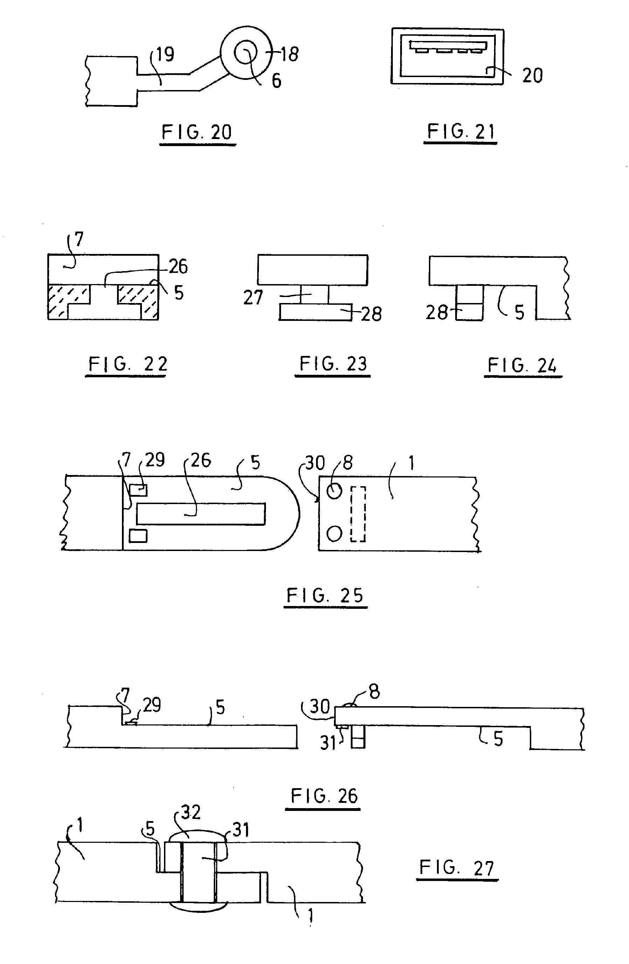

Figur 20 zeigt, dass eine solche das Loch 6 aufweisen Öse 18 auch über einen abgewinkelten Verbindungssteg 19 oder auch über einen schräg verlaufen Verbindungssteg 19 mit dem Leiterplattenmodul 1 verbunden sein kann.

Figur 21 zeigt eine Stirnansicht eines Leiterplattenmoduls, die eine Buchse 20 aufweist, die als USB-Buchse ausgebildet ist. An diesem Ende kann ein USB-Stecker oder ein USB-Stick eingesteckt werden. Dieser kann beispielsweise zur Energieversorgung dienen, wenn er eine Batterie oder einen Akkuemulator enthält.

Eine solche USB-Buchse 20 kann natürlich auch an anderen Stellen einer Leiterplatte angeordnet sein, beispielsweise an der Seitenkante.

Die Figuren 22 bis 24 zeigen Möglichkeiten, wie zwei Module 1 in ähnlicher Weise miteinander verbunden werden können, wie dies die Figur 18 zeigt. Das eine Modul, dargestellt in Figur 22, enthält in dem die Stufe 5 aufweisenden vorderen Bereich einen T-förmigen Schlitz 26, wobei der Steg des T zur Stufe 15 gerichtet ist, während die Verbreiterung unterhalb der Stufe 5 vorhanden ist. Das Gegenstück, das in Stirnansicht in Figur 23 dargestellt ist, enthält unterhalb der Stufe 5 über einen Steg 27 verbunden eine Querplatte 28. Die Breite der Querplatte 28 entspricht der Breite des unteren Teils des Schlitzes 26, während die Dicke sowohl des Stegs 27 als auch der Querplatte 28 gemessen in Längsrichtung des Moduls, siehe Figur 24, der Breite des oberen Teils des Schlitzes 26 entspricht. Dadurch lässt sich der Ansatz an der Unterseite des rechten Moduls nach Querstellung durch den oberen Teil 26 des Schlitzes hindurch führen, worauf dann eine Geraderichtung der beiden Module in der Weise erfolgt, dass sie in gegenseitiger Verlängerung angeordnet sind. Auf diese Weise wird eine verschiebbare Verbindung der beiden Teile ermöglicht. Die elektrische Verbindung kann über Schleifkontakte oder ähnliches erfolgen.

Figur 25 zeigt eine Anwendung eines solchen Prinzips bei zwei speziellen Leiterplattenmodulen.

Das linke Leiterplattenmodul weist in dem die Stufe 5 aufweisenden Bereich einen Längsschlitz 26 wie in Figur 22 auf. Unmittelbar an der Begrenzungswand 7 der Stufe 5 sind auf der Oberseite der Stufe 5 zwei leitende Flächen 29 angeordnet, die mit der Leiterplatte in Verbindung stehen.

Auf der Unterseite der Stufe 5 des rechten Leiterplattenmoduls 1 sind mit einem Abstand von der Stirnkante 30, der dem Abstand der leitenden Flächen 29 von der Begrenzungswand 7 entspricht, ebenfalls leitende Flächen als Kontaktflächen 31 angeordnet. Wird das rechte Modul nach dem Verbinden, wie dies bei der Ausführungsform nach Figur 22 bis 24 beschrieben wurde, nach links verschoben, bis die Stirnkante 30 an der Begrenzungswand 27 anliegt, gelangen die Kontakte 29 auf der Oberseite der Stufe 5 und 31 auf der Unterseite der Stufe 5, miteinander in Kontakt, wodurch beispielsweise auf der Oberseite des rechten Moduls vorhandene LEDs 8 eingeschaltet werden können. Zieht man dagegen die beiden Leiterplattenmodule etwas auseinander, geraten die leitenden Flächen 31, 32 außer Kontakt und die LEDs 8 erlöschen. Man kann auf diese Weise beim Längenausgleich dafür sorgen, dass ein bestimmtes Rastermaß an den leuchtenden Dioden 8 beibehalten bleibt.

Bringt man in die Kontaktelemente 29 auf der Stufe 5 in einem größeren Abstand von der Begrenzungswand 7 an, so kann man auch die umgekehrte Anordnung treffen, dass nämlich bei vollständig zusammengeschobenen Leiterplattenmodulen 1, also bei Anliegen der Stirnfläche 30 an der Begrenzungswand 7, kein Kontakt zwischen den Leiterflächen 29, 31 vorhanden ist. Erst dann, wenn die beiden Leiterplattenmodule auseinander gezogen werden, wird der Kontakt hergestellt, so dass dann die Leuchtdioden 8 eingeschaltet werden. Es ist auf diese Weise möglich, durch unterschiedliche Anordnung auch Schaltvorgänge durchzuführen. Was hier für die Schiebeverbindung von zwei Leiterplattenmodulen ausgesagt ist, kann selbstverständlich auch bei einer Drehgelenkverbindung zweier Leiterplatten verwirklicht werden, indem man die speziellen Schleifkontakte nur in bestimmten Winkelpositionen vorsieht.

Figur 27 zeigt nochmals schematisch ein Beispiel der Verbindung der einander zugewandten Enden zweier Leiterplattenmodule 1. Die beiden Leiterplattenmodule 1 liegen im Bereich einer durchgehenden Öffnung mit ihren Stufen 5 aufeinander. Durch die fluchtenden Öffnungen ist ein Hohlniet 31 hindurchgeführt, der mit seinen beiden Köpfen 32 die Leiterplatten festlegt.

Anstelle eines Hohlniets oder eines Blindniets kann natürlich auch eine Schraube hindurchgeführt werden, die auf der einen Seite einen Schraubenkopf aufweist und auf der anderen Seite mithilfe einer Mutter und einer Unterlegscheibe die beiden Teile zusammenhält. Eine Holzschraube oder Spanplattenschraube kann auch dazu dienen, die beiden Teile nicht nur miteinander, sondern auch mit einer Unterlage zu verbinden. Dies kann auch unter Zwischenlage einer Abstandhülse erfolgen, wenn die beiden Leiterplattenmodule nicht direkt auf der Unterlage aufliegen sollen.

## Patentansprüche

1. Leiterplattenmodul, mit
1. 1 einer Leiterplatte,
1.2 in der Leiterplatte angeordneten Leiterbahnen (14), sowie mit
1.3 mindestens einer an der Leiterplatte ausgebildeten Verbindungseinrichtung zur
1.3.1 direkten mechanischen und
1.3.2 elektrischen Verbindung mit einem eine gleichartige Verbindungseinrichtung aufweisenden Leiterplattenmodul.

2. Leiterplattenmodul nach Anspruch 1, mit einer eine Einkopplung der Stromversorgung der Leiterbahnen (14) ermöglichenden Ankoppeleinrichtung zur Bildung eines Endmoduls (11).

3. Leiterplattenmodul nach Anspruch 1 oder 2, mit zwei Verbindungseinrichtungen zur Bildung eines Mittelmoduls.

4. Leiterplattenmodul nach einem der vorhergehenden Ansprüche, mit mindestens einer mit den Leiterbahnen (14) verbundenen Licht abstrahlenden Komponente, insbesondere einer LED (8) oder organischen LED.

5. Leiterplattenmodul nach einem der vorhergehenden Ansprüche, mit mindestens einem elektronischen Bauteil zur Bildung eines Funktionsmoduls.

6. Leiterplattenmodul nach einem der vorhergehenden Ansprüche, mit mindestens einem Logikbauteil zur Bildung eines Logikmoduls.

7. Leiterplattenmodulen nach einem der vorhergehenden Ansprüche, bei dem das Leiterplattenmodul leistenförmig ausgebildet ist.

8. Leiterplattenmodul nach einem der vorhergehenden Ansprüche, bei den das Leiterplattenmodul abgewinkelt ausgebildet ist.

9. Leiterplattenmodul nach einem der vorhergehenden Ansprüche, bei dem das Leiterplattenmodul leistenförmig mit einer Abzweigung und gegebenenfalls drei oder mehr Verbindungseinrichtungen ausgebildet ist.

10. Leiterplattenmodul nach einem der vorhergehenden Ansprüche, bei dem das Modul als geradlinig verlaufende Leiste ausgebildet ist.

11. Leiterplattenmodul nach einem der Ansprüche 1 bis 9, bei dem das Modul als eine in einer Dimension gebogene Leiste ausgebildet ist.

12. Leiterplattenmodul nach einem der vorhergehenden Ansprüche, bei dem das Leiterplattenmodul als starr-flexible Leiterplatte ausgebildet ist.

13. Leiterplattenmodul nach einem der vorhergehenden Ansprüche, bei dem die Verbindungseinrichtung derart ausgebildet ist, dass zwei benachbarte Module in unterschiedlichen Positionen miteinander verbindbar sind.

14. Leiterplattenmodul nach einem der vorhergehenden Ansprüche, bei dem die Verbindungseinrichtung scharnierartig aufgebaut ist, wobei die Scharnierachse senkrecht zur Ebene der Leiterplattenmodule verläuft.

15. Leiterplattenmodul nach einem der vorhergehenden Ansprüche, bei dem die Verbindungseinrichtung Kontaktelemente aufweist, die in verbundenen Zustand flächig aneinander anliegen.

16. Leiterplattenmodul nach einem der vorhergehenden Ansprüche, bei dem die Kontaktelemente der Verbindungseinrichtung als Schleifringe (13) ausgebildet sind.

17. Leiterplattenmodul nach einem der vorhergehenden Ansprüche, bei dem ein mechanisches Verbindungselement als Leiter wirkt.

18. Leiterplattenmodul nach einem der vorhergehenden Ansprüche, bei dem ein die Scharnierachse bildendes mechanisches Verbindungselement als Leiter wirkt.

19. Leiterplattenmodul nach einem der vorhergehenden Ansprüche, bei dem die Verbindungseinrichtung mehrere Leiterbahnen (14) miteinander verbindet.

20. Leiterplattenmodul nach einem der vorhergehenden Ansprüche, bei dem Licht abstrahlende Komponenten, insbesondere LEDs (8) oder organische LEDs an mehr als einer Seite, insbesondere an allen Seiten des Leiterplattenmoduls angeordnet sind.

21. Leiterplattenmodul nach einem der vorhergehenden Ansprüche, insbesondere Anspruch 20, bei dem die LEDs eines Leiterplattenmoduls durch einen in diesem oder einem anderen Leiterplattenmodul angeordneten Logikbaustein einzelnen oder in Gruppen ansteuerbar sind.

22. Leiterplattenmodul nach einem der vorhergehenden Ansprüche, bei dem der Querschnitt quadratisch oder angenähert quadratisch ist, zur Bildung eines Stabes.

23. Leiterplattenmodul nach einem der vorhergehenden Ansprüche, bei dem der Träger abweichend von dem üblichen Leiterplattenmaterial aus anderem Material besteht, beispielsweise spritzgegossen oder Keramik, während die Leiter und/oder Kontakte chemisch und/oder galvanisch erzeugte metallische Kontakte oder elektrisch leitende Pasten sind.

24. Leiterplattenmodul nach einem der vorhergehenden Ansprüche, bei dem eine Verbindungsstelle zur Verbindung mit mehr als einem Leiterplattenmodul in sternförmiger Anordnung ausgebildet ist.

25. Leiterplattenmodul nach einem der vorhergehenden Ansprüche, bei dem bei zwei scharnierartigen Verbindungseinrichtungen die Scharnierachse der Verbindungseinrichtung an dem einen Ende senkrecht zur Scharnierachse der Verbindungseinrichtung an dem anderen Ende angeordnet ist.

26. Leiterplattenmodul nach einem der vorhergehenden Ansprüche, mit mehrlagigem Aufbau.

27. Leiterplattenmodulen nach einem der vorhergehenden Ansprüche, mit einer Schubgelenkverbindung mit dem benachbarten Leiterplattenmodul.

28. Leiterplattenmodulen nach Anspruch 27, mit einem Längenausgleich in der Gelenkverbindung.

29. Leiterplattenmodule nach einem der vorhergehenden Ansprüche, mit einer Schalteinrichtung in der Verbindungsstelle mit einem benachbarten Leiterplattenmodul, betätigbar insbesondere durch Änderung der gegenseitigen Zuordnung der beiden Leiterplattenmodule.

30. Leiterplattenmodul nach einem der vorhergehenden Ansprüche, mit einer Steckbuchse, insbesondere einer USB-Schnittstelle (20).

31. Leiterplattenmodul nach einem der vorhergehenden Ansprüche, mit einer Klinkensteckerbuchse.

32. Leiterplattenmodul nach einem der vorhergehenden Ansprüche, mit einer ansteckbaren Energieversorgung.

33. Anordnung aus mehreren miteinander verbundenen Leiterplatten nach einem der vorhergehenden Ansprüche.
